# EUROPEAN PATENT APPLICATION

(11) **EP 2 587 121 A1**
(43) Date of publication of application: **01.05.2013**
(21) Application number: 11187044.0
(22) Date of filing: 28.10.2011
(51) Int. Cl.: F21S 8/12, F21S 8/10, F21V 7/00

(54) **LED-based lighting with reflector mounted on PCB**

(71) Applicant: Hella KGaA Hueck & Co., 59552 Lippstadt (DE)
(72) Inventor: Kerpe, Alexander, 59555 Lippstadt (DE)
(74) Representative: Lohr, Georg

(57) **Abstract**

A LED-based lighting component is disclosed. It comprises of a plurality of LEDs mounted to a printed circuit board. Furthermore, a surface mount reflector of a metal sheet with punched out reflector surfaces is located on the printed circuit board. The surface mount reflector forms at least two reflectors at opposing sides of each LED, reflecting and/or shading light from the LED. The surface mount reflector and the printed circuit board are held together within a frame.

## Description

### Field of the invention

The invention relates to a LED-based lighting component and to an assembly method of such a component. It specifically relates to a reflector mounted to a printed circuit board holding LEDs.

### Description of the related art

LED lighting systems offer significant advantages over traditional incandescent, HID and fluorescent lamps. LEDs are of smaller size, offer higher reliability, longer operational life and lower energy consumption. However, there are specific requirements when using LEDs. As increased operating temperature significantly reduces lifetime, cooling is of high importance. Furthermore, most LED chips are approximately isotropic light sources with a lambertian light distribution, which must be adapted to specific requirements of a lighting system.

The US patent application publication 2008/027894181 A1 discloses a printed circuit board with LEDs soldered thereon. For adapting the light distribution, injection molded reflectors are positioned above each individual LED. The disadvantage is that the reflectors must be manually assembled to the printed circuit board. This is a complex and time-consuming step. Furthermore, the reflectors are comparatively complex and expensive. Because assembly is a different manufacturing step, the requirements of the assembly process with respect to tolerances and the risk of mechanical damages is very high.

### Summary of the invention

The problem to be solved by the invention is to provide means for cooling and adapting the light distribution of LEDs mounted to a carrier like a printed circuit board. Furthermore, the solution should be inexpensive and suitable for manufacturing in large volumes.

Solutions of the problem are described in the independent claims. The dependent claims relate to further improvements of the invention.

A preferred embodiment relates to a LED-based lighting component comprising a printed circuit board and a plurality of LEDs mounted thereon. Preferably, a reflector is placed on the printed circuit board. Preferably, the reflector is a surface mount component. This means it is a component to which the surface mount technology is applicable, which may be mounted on soldering pads at the printed circuit board or glued to the surface of the printed circuit board. Usually surface mount components do not require holes or are otherwise penetrating the printed circuit board. Anyway, there may be specific embodiments of the surface mounted reflector which have posts to be held within holes of the printed circuit board. Preferably the surface mount reflector is of sheet metal with reflector surfaces formed thereof. It may also comprise any ceramic or plastic materials, which withstand the soldering process. Preferably, these materials have at least one metallized or at least light reflecting surface. The reflector surfaces extend over the surface of the printed circuit board. They guide the light of the LED chips, which often have an approximated lambertian light distribution. The surface mount reflector can easily be manufactured from sheet metal by a simple process of punching and bending the reflector surfaces of the main plane, which is defined by the metal sheet. This allows for a precise and inexpensive manufacturing process of high volumes of the surface mount reflector.

It is further preferred, if the surface mount reflector has at least one mounting pad. Most preferably, the surface mount reflector has at least two, three or four mounting pads. The surface mount reflector may be mounted to the printed circuit board by gluing or soldering preferably of the at least one mounting pad to the printed circuit board. Most preferably the surface mount reflector is placed to the printed circuit board by a SMD pick and place machine. Preferably, this is done in the same process as placing the LEDs and other electronic components to the printed circuit board, thus reducing tolerances and assembly time.

Furthermore, the printed circuit board may be inserted into a frame. For this purpose, the frame may have one or two braces. The frame may also serve as mechanical support, a heat sink or as an insulator of the assembly. The frame may be a strand casted, pultruded or extruded profile. It preferably has overhangs to hold the surface mount reflector down to the printed circuit board and further to fix the reflector and the printed circuit board within the frame. To improve the fixation within the frame, the reflector may have springs. These assert a predetermined force to the reflector and therefore to the printed circuit board. This may further press the printed circuit board to the frame, further improving heat transfer to the frame. For easy assembly the printed circuit board is pushed into an opening at the end of the profile. Slipping of the printed circuit board within the profile my may be prevented by end caps or by a lug or a screw.

According to a further preferred embodiment, a surface mount reflector comprises at least one reflector surface. The surface mount reflector is preferably made of metal, which may be aluminum or brass, or any other material, which has a light reflecting surface. Most preferably the surface mount reflector is a metal sheet and the at least one reflector surface is punched from this metal sheet. The at least one reflector surface may be part of the surface of the metal sheet which is bent into an angle from a main plane of the metal sheet. Preferably, the surface mount reflector has at least one mounting pad for mounting the surface mount reflector to a printed circuit board. It is most preferred to have at least two, three or four mounting pads to allow stable positioning of the surface mount reflector on the printed circuit board.

In a further embodiment, the surface mount reflector has at least one blanking or opening for the at least one LED, thus surrounding the LED on the printed circuit board. The surface mount reflector may have further blankings leaving space for further electronic components on the printed circuit board.

In a preferred embodiment, the printed circuit board has a first surface mount reflector and a second surface mount reflector, being located at opposing sides of a LED. In another embodiment, the printed circuit board has four surface mount reflectors being located at or four sides of a rectangular LED. There may be any other number or any other shape of the surface mount reflectors.

Although it is preferred, that the surface mount reflectors reflect light from the LED into a different direction than it was emitted from the LED, the surface mount reflector may also and/or alternatively shade light from the LED, thus preventing light radiating into unwanted directions.

A further advantage is that the surface mount reflector may act as a heat sink for dissipating heat from the LED. For this purpose it is preferred if the surface mount reflector comprises of a heat conductive material. It is further preferred, if the surface mount reflector is mounted close to the LED and preferably contacts at least the same metallized layer as the thermal interface of the LED to improve heat transfer.

In a further embodiment, the surface mount reflector may be mounted at the opposite side of the LEDs of the printed circuit board. In this case, the printed circuit board may have at least one opening or slot, through which the individual surface mount reflector surfaces can penetrate the printed circuit board.

In a further embodiment, a frame may be provided. The frame may act as at least one of a mechanical support, a heat sink, an insulator. The frame may interact with springs on the surface mount reflectors for pressing the printed circuit board to the frame and therefore improving heat transfer. Preferably, the frame is a profile, which may be manufactured by strand casting or pultrusion or extrusion. The frame is preferably made of metal or ceramics, most preferably of aluminum.

Mounting the printed circuit board within the frame is a very simple procedure. The first step the surface mount reflector is positioned on or preferably fixed to the printed circuit board. In the next step, the printed circuit board is inserted into the frame by pushing them into a slot opening at one end of the frame. The frame may further support alignment of the surface mount reflector and the printed circuit board.

By means of a flat spring of the at least one surface mount reflector, the printed circuit board is held in a predetermined position relative to the frame.

This embodiment results in a defined pressure of the printed circuit board (PCB) to the frame without any additional elements (e.g. screws, glue,..). Due to the permanent elastic deformation of the flat spring, the thermal resistance between the PCB and the frame will not change over lifetime.

A method according to the invention comprises at least the steps of placing at least one LED on a printed circuit board and placing at least a surface mount reflector to the same printed circuit board in the proximity of the at least one LED. The sequence of these steps can be reversed. Both steps are preferably done within the same manufacturing process. It is preferred, if both steps are done by pick and place machines. Therefore, no manual handling of the components is necessary. Consequently, a very high precision of placement and very low mechanical tolerances specifically of the relative positions of the at least one LED and the at least one surface mount reflector can be achieved. This results in low tolerances of the optical system and a very precise radiation pattern. Furthermore automatic handling prevents damaging or at least maladjustment of the at least one surface mount reflector. Most preferably, precision can be further increased by doing both steps with the same pick and place machine. After placing the at least one LED and the at least one surface mount reflector to the printed circuit board, it may be heated by a reflow oven and/or a solder wave to solder the at least one LED and the at least one surface mount reflector to the printed circuit board.

### Description of Drawings

In the following, the invention will be described by way of example, without limitation of the general inventive concept, on examples of embodiment with reference to the drawings.
Figure 1 shows a preferred embodiment of the invention.
Figure 2 shows the preferred embodiment in a side view.
Figure 3 shows the preferred embodiment in a sectional view.
Figure 4 shows the preferred embodiment assembled into a frame.
Figure 5 shows a second embodiment of the invention.
Figure 6 shows the second embodiment in a side view.
Figure 7 shows another embodiment, with four reflector surfaces.
Figure 8 shows a basic arrangement of a surface mounted reflector.
Figure 9 shows a circular surface mount reflector. A
Figures 10 to 14 show different embodiments of surface mounted reflectors.

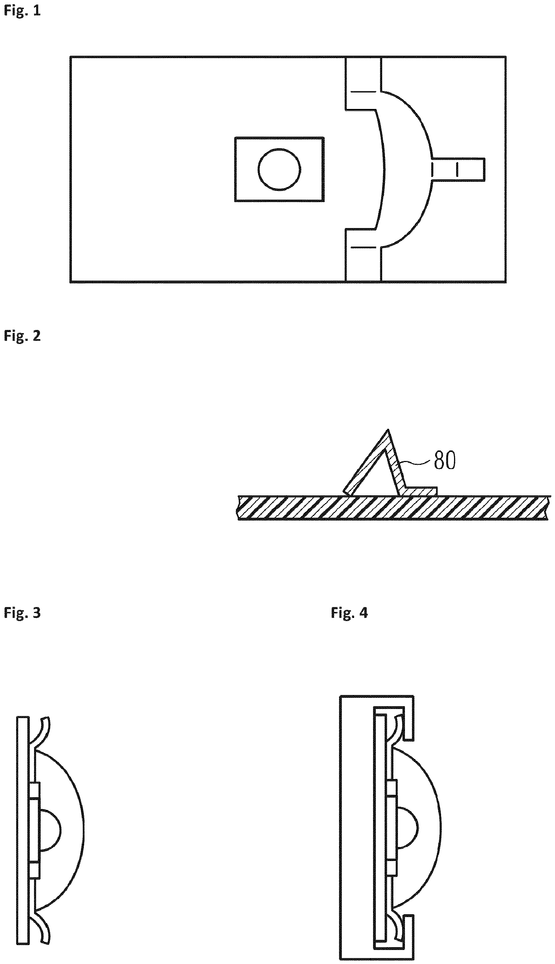

In figure 1, a preferred embodiment according to the invention is shown. A LED 20 is mounted to a printed circuit board 10. Furthermore, two surface mount reflectors 80, 90 are located on the printed circuit board. These surface mount reflectors each have at least one reflecting surface 81, 91. Preferably, the surface mount reflectors 80, 90 have at least one, preferably three or four mounting pads 82, 83, 84, 92, 93, 94 for mounting and fixing the surface mount reflectors to the surface of the printed circuit board. These mounting pads may be glued and/or soldered to the printed circuit board. The surface mount reflectors may be placed at the printed circuit board by a pick and place machine. Furthermore there may be flat springs 85, 86, 95, 96. In general, there may be any number of LEDs and of surface mount reflectors on the printed circuit board.

Figure 2 shows the preferred embodiment in a side view. Here the surface mount reflectors 80, 90 are shown from their sides standing with the mounting pads 82, 84, 92, 94 on the printed circuit board 10.

In figure 3, a sectional view is shown. It specifically shows the flat Springs 85 and 86 extending from mounting pads 82 and 83.

In figure 4, an embodiment with assembled printed circuit board and frame is shown. The printed circuit board 10 is assembled with a frame 100. The frame has at least one overhang 101, 102, preferably two overhangs, to hold the printed circuit board 10 together with surface mount reflector 80 within the frame. The at least one overhang 100 preferably interacts with the at least one flat spring 85, 86 to assert a predetermined force to the surface mount reflector. Frame 100 may be designed to act as a mechanical support structure and/or a heat sink and/or electrical insulator for the assembly.

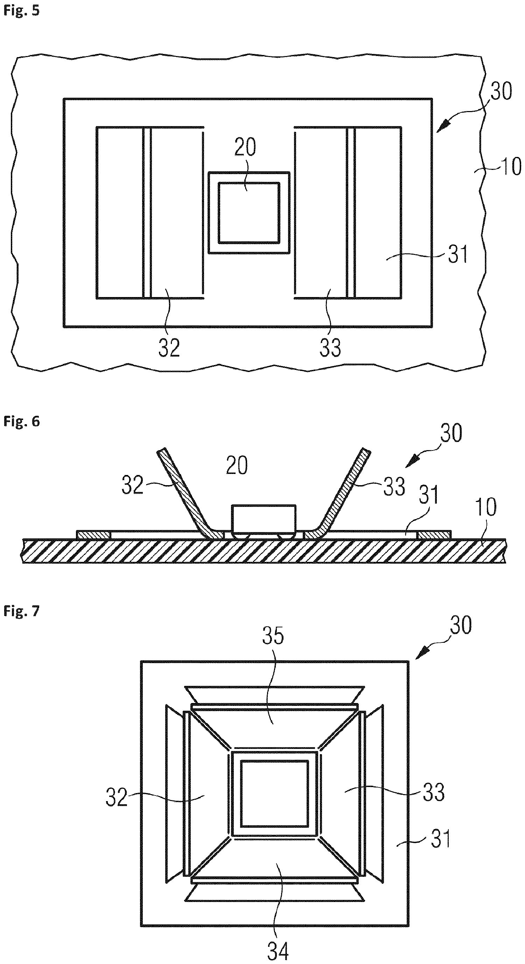

In figure 5, a further embodiment according to the invention is shown. At least one LED 20 is mounted to a printed circuit board 10. Furthermore, a surface mount reflector 30 is located on the printed circuit board. This surface mount reflector has at least one blanking or opening 36 for a LED. It further has at least one reflector surface 32. Preferably, there is at least a second reflector surface 33, preferably at the opposite side of the LED in relation to the first reflector 32 surface. Preferably, the reflector surfaces 32, 33 are punched out and bent upwards from the surface mount reflector. This may result in at least one additional blanking 37. There may be further electronic components like LED drivers placed on the printed circuit board within the at least one additional blanking 37.

Figure 6 shows this embodiment in a side view. Here the surface mount reflector 30 is shown from its side with the reflector surfaces 32, 33 bent upwards in an angle from the reflector base 31, which is located on the printed circuit board 10.

Figure 7 shows another embodiment, where four reflector surfaces are provided. A first reflector surface 32, second reflector surface 33, third reflector surface 34 and fourth reflector surface 35 enclose the LED, which is placed on a printed circuit board within blanking 36 at four sides.

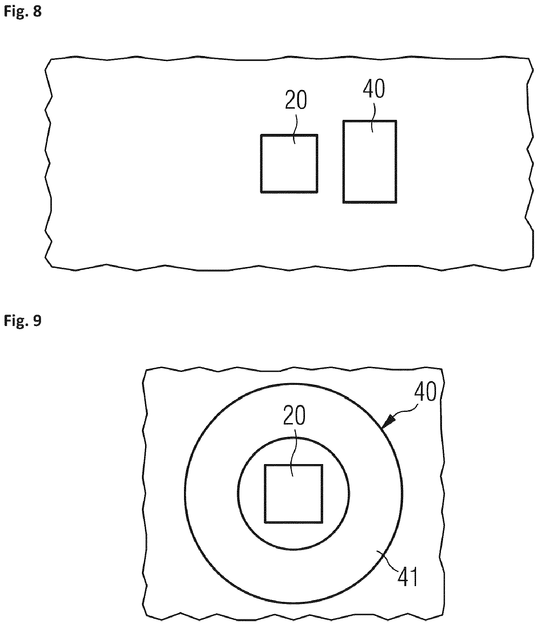

Figure 8 shows a basic arrangement of a surface mounted reflector 40 in relationship to a LED 20. The surface mount reflector 40 is a component, which is mounted in close proximity to the LED 20 with its reflecting surface 41 directed towards the LED. There may be further surface mount reflectors 40a with reflecting surfaces 41a arranged in close proximity to the LED 20.

Figure 9 shows a circular surface mount reflector 40 having a reflecting surface 41 around LED 20.

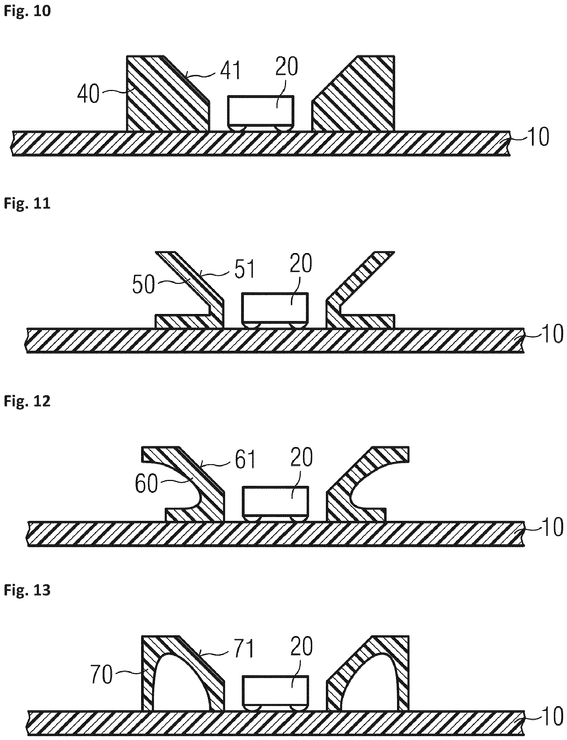

Figures 10 to 14 show different embodiments of surface mounted reflectors 40, 50, 60, 70 with their reflecting surfaces 41, 51, 61, 71 directed towards LED 20 mounted on the printed circuit board 10.

**List of reference numerals**
- 10: printed circuit board
- 20: LED
- 30: surface mount reflector
- 31: reflector base
- 32, 33, 34, 35: reflector surfaces
- 36: blanking for LED
- 37: blanking
- 40, 50, 60, 70: surface mount reflectors
- 41, 51, 61, 71: reflector surfaces
- 80: surface mount reflector
- 81: reflector surface
- 82, 83, 84: mounting pads
- 85,86: flat springs
- 90: surface mount reflector
- 91: reflector surface
- 92, 93, 94: mounting pads
- 95, 96: flat springs
- 100: frame
- 101, 102: overhang

## Claims

1. LED-based lighting component comprising at least:
- at least one LED (20) mounted to a printed circuit board (10)
- at least one surface mount reflector (80) located on the printed circuit board, the surface mount reflector having at least one reflector surface (81) oriented towards the at least one LED.

2. LED-based lighting component according to claim 1,
**characterized in, that**
the at least one surface mount reflector comprises of a metal sheet.

3. LED-based lighting component according to any one of the preceding claims,
**characterized in, that**
the at least one surface mount reflector comprises any ceramic or plastic material, which withstand the soldering process.

4. LED-based lighting component according to any one of the preceding claims,
**characterized in, that**
the at least one surface mount reflector comprises at least one heat conductive material.

5. LED-based lighting component according to any one of the preceding claims,
**characterized in, that**
the at least one surface mount reflector is thermally connected to the at least one LED to act as a heat sink.

6. LED-based lighting component according to any one of the preceding claims,
**characterized in, that**
a first surface mount reflector (80) and the second surface mount reflector (90) are located at opposing sides of the at least one LED (20).

7. LED-based lighting component according to any one of the preceding claims,
**characterized in, that**
the component comprises a frame (100) for holding the printed circuit board (10).

8. LED-based lighting component according to claim 8,
**characterized in, that**
the surface mount reflector (80) has at least one spring (85, 86) to interact with the frame (100) to hold the surface mount reflector (80) down to the printed circuit board (10).

9. Method for manufacturing a LED-based lighting component according to any one of the preceding claims, comprising the steps of:
a) positioning and fixing at least one LED (20) on a printed circuit board (10), and
b) positioning and fixing a surface mount reflector (80) on a printed circuit board (10).

10. Method for manufacturing a LED-based lighting component according to claim 9,
**characterized in, that**
both steps are done with the same pick and place machine.
